# EUROPEAN PATENT SPECIFICATION

(11) **EP 4 336 196 B1**
(45) Date of publication and mention of the grant of the patent: **01.07.2026**
(21) Application number: 23192968.8
(22) Date of filing: 23.08.2023
(51) Int. Cl.: G01R 31/28, G01R 35/00

(54) **ENVIRONMENT FORMING DEVICE**
UMGEBUNGSERZEUGUNGSVORRICHTUNG
DISPOSITIF DE FORMATION D'ENVIRONNEMENT

(30) Priority: 30.08.2022 JP 2022137112
(43) Date of publication of application: 13.03.2024
(73) Proprietor: Espec Corp., Kita-ku Osaka-shi Osaka 530-8550 (JP)
(72) Inventor: KUBOTA, Yoshio, Osaka, 530-8550 (JP); MAKINO, Toshiaki, Osaka, 530-8550 (JP); KADO, Yuuki, Osaka, 530-8550 (JP); OKAZAWA, Takashi, Osaka, 530-8550 (JP)
(74) Representative: SSM Sandmair

(56) References cited:
- US-A1- 2021 302 498
- US-A1- 2022 043 056
- US-A1- 2022 058 097

## Description

### Field of the Invention

The present invention relates to an environment forming device.

### Background Art

For example, JP 2014-66593 A discloses a constant temperature constant humidity apparatus for an environment test according to the background art. As an electric apparatus for adjusting environment in a test chamber, the constant temperature constant humidity apparatus includes a refrigerator, a heater, a dehumidifier, and a humidifier.

Furthermore, an oscilloscope according to the background art is disclosed in, for example, Japanese Patent No. 2817179.

In an environment forming device such as a constant temperature constant humidity apparatus, when a performance test is performed before shipment or when a failure occurs after shipment, an operator uses a measuring instrument such as an oscilloscope or a noise data logger to perform a work of specifying a spot affected by noise which may cause a defect.

However, since specialist knowledge is required to handle these measuring instruments, applicable workers are limited. Therefore, it is demanded to realize a means enabling a spot affected by noise to be easily specified without using a measuring instrument such as an oscilloscope. In addition, since identification of a spot affected by noise using a measuring instrument is an ex post facto work, it may be difficult to reproduce an occurrence situation of a defect. Therefore, it is demanded to realize a means enabling an influence level of noise and the like to be measured in real time at the time of driving an environment forming device.

Further relevant prior art is disclosed in US 2021/302498 Al which relates to a testing system with a controlled environmental chamber and discloses validating proper function of the test equipment itself with respect to electrostatic discharge by checking correct transmission of digital signals.

### Summary of the Invention

An object of the present invention is to obtain an environment forming device capable of easily specifying a spot affected by noise without using a measuring instrument such as an oscilloscope and of evaluating an influence level of noise and the like in real time at the time of driving an environment forming device.

An environment forming device according to a first aspect of the present invention is defined in independent claim 1.

According to the present aspect, the first detection part detects a code error occurring in the digital signal received by the first reception part, and the evaluation part evaluates an influence of noise on the electric apparatus based on a detection result obtained by the first detection part. It is accordingly possible to easily specify a spot affected by noise without using a measuring instrument such as an oscilloscope and evaluate an influence level of noise and the like in real time at the time of driving a device.

According to an environment forming device of a second aspect of the present invention, in the environment forming device of the first aspect, the at least one electric apparatus includes a plurality of electric apparatuses, the at least one first communication device includes a plurality of first communication devices, each of the plurality of first communication devices being connected to each of the plurality of electric apparatuses, the first reception part receives the digital signal transmitted by the first transmission part included in each of the plurality of first communication devices, the first detection part detects a code error occurring in the digital signal received by the first reception part for each of the plurality of first communication devices, and the evaluation part evaluates an influence of noise on each of the plurality of electric apparatuses.

According to the present aspect, the first detection part detects a code error occurring in the digital signal received by the first reception part for each of the plurality of first communication devices, and the evaluation part evaluates an influence of noise on each of the plurality of electric apparatuses. It is accordingly possible to simultaneously measure noise at a plurality of spots in the environment forming device, resulting in enabling a spot affected by noise, a propagation path, or the like of noise to be specifically specified.

An environment forming device of a third aspect of the present invention further includes, in the environment forming device of the first or second aspect: a measuring apparatus that can be affected by noise; and a second communication device that communicates with the control device and the measuring apparatus. The measuring apparatus is at least one of a temperature sensor, a humidity sensor, and a pressure sensor. The measuring apparatus includes a second transmission part that transmits a digital signal toward the second communication device, the second communication device includes: a second reception part that receives the digital signal transmitted by the second transmission part; a second detection part that detects a code error occurring in the digital signal received by the second reception part; and a second transmission part that transmits data indicating a detection result obtained by the second detection part to the control device, the first reception part further receives the data transmitted by the second transmission part, and the evaluation part further evaluates an influence of noise on the measuring apparatus based on a detection result obtained by the second detection part, the detection result being indicated by the data received by the first reception part.

According to the present aspect, the second detection part detects a code error occurring in the digital signal received by the second reception part, and the evaluation part evaluates an influence of noise on the measuring apparatus based on a detection result obtained by the second detection part. Accordingly, with respect not only to the electric apparatus but also to the measuring apparatus, it is possible to easily specify a spot affected by noise without using a measuring instrument such as an oscilloscope and evaluate an influence level of noise and the like in real time at the time of driving a device.

An environment forming device of a fourth aspect of the present invention further includes, in the environment forming device of any one of the first to third aspects, a display device that displays an image indicating an evaluation result obtained by the evaluation part.

According to the present aspect, it is possible to visualize an evaluation result obtained by the evaluation part and provide the evaluation result to an operator.

According to an environment forming device of a fifth aspect of the present invention, in the environment forming device of any one of the first to fourth aspects, the control device further includes a storage unit that stores data indicating an evaluation result obtained by the evaluation part.

According to the present aspect, since the data indicating an evaluation result obtained by the evaluation part is stored in the storage unit, it is possible to perform a detailed analysis of a cause of noise generation and the like using the data stored in the storage unit afterwards.

According to an environment forming device of a sixth aspect of the present invention, in the environment forming device of the fifth aspect, the control device further includes a control part, the control part storing the data indicating the evaluation result obtained by the evaluation part in the storage unit in association with operation information of the environment forming device.

According to the present aspect, since the data indicating the evaluation result obtained by the evaluation part is stored in the storage unit in association with the operation information of the environment forming device, it is possible to analyze a cause-and-effect relation, a correlation, or the like between drive of each electric apparatus and noise generation in detail.

### Brief Description of the Drawings

Fig. 1 is a diagram illustrating a simplified overall configuration of an environment testing device.
Fig. 2 is a diagram illustrating a simplified configuration of each part of the environment testing device.
Fig. 3 is a diagram illustrating a first example of a display mode of an evaluation result in a simplified manner.
Fig. 4 is a diagram illustrating a second example of the display mode of an evaluation result in a simplified manner.
Fig. 5 is a diagram illustrating a third example of the display mode of an evaluation result in a simplified manner.

### Description of Embodiments

In the following, an embodiment of the present invention will be described in detail with reference to the accompanying drawings. Note that elements denoted by the same reference numerals in different drawings represent the same or corresponding elements.

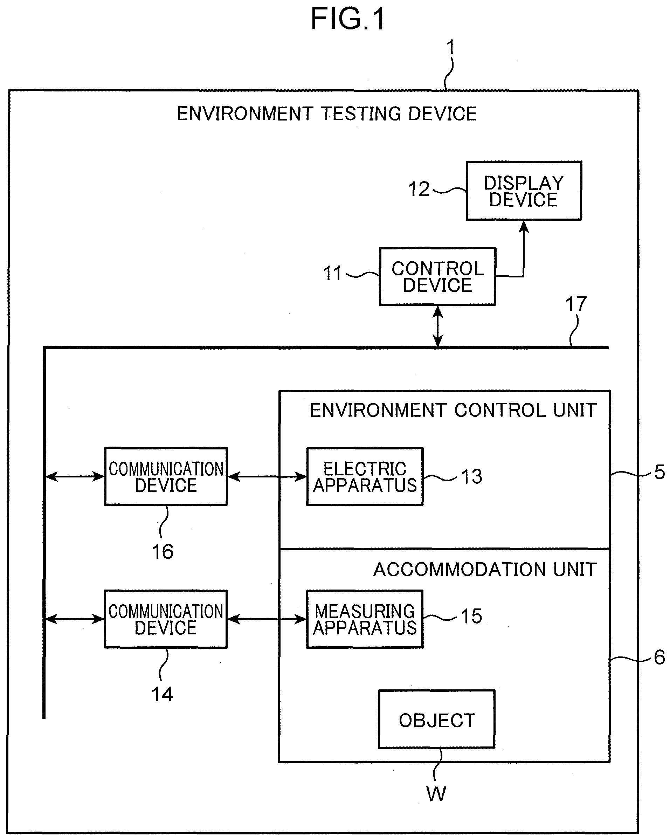

Fig. 1 is a diagram illustrating a simplified overall configuration of an environment testing device 1 according to an embodiment of the present invention. The environment testing device 1 includes an accommodation unit 6 in which a test object W is accommodated, and an environment control unit 5 that controls an environment in the accommodation unit 6. The accommodation unit 6 is a chamber surrounded by a heat-insulating housing, and the object W is accommodated inside the chamber. The object W is, for example, an electronic component such as a circuit board. The environment testing device 1 further includes a control device 11, a display device 12, an electric apparatus 13, a communication device 14, a measuring apparatus 15, and a communication device 16.

At least one electric apparatus 13 is installed in the environment control unit 5. At least a part of the electric apparatus 13 may be disposed outside the environment control unit 5. A plurality of electric apparatuses 13 are installed in the environment control unit 5 in the example of the present embodiment. The electric apparatus 13 includes a heater that heats air in the accommodation unit 6. The electric apparatus 13 also includes a cooling device that cools the air in the accommodation unit 6. In addition, the electric apparatus 13 includes a humidifier that humidifies the air in the accommodation unit 6. In addition, the electric apparatus 13 includes a refrigerator or a dehumidifier that dehumidifies the air in the accommodation unit 6. The electric apparatus 13 controls temperature, or temperature and humidity of an environment in the accommodation unit 6 by drive control from the control device 11. Note that the above configuration of the environment control unit 5 is an example, and can be changed with a control target of the environment in the accommodation unit 6. For example, when a control target of the environment is only the temperature, only the heater may be used. Furthermore, the environment control unit 5 may control a pressure of the environment in the accommodation unit 6. In this case, the electric apparatus 13 may include a decompressor and/or a pressurizer or the like. The communication device 16 (first communication device) such as a communication substrate and/or an input/output substrate, or the like is connected to each of the plurality of electric apparatuses 13. The communication device 16 is disposed outside the environment control unit 5. The communication device 16 is connected to the control device 11 via a communication network 17 using a LAN cable or the like. The communication device 16 communicates between the electric apparatus 13 and the control device 11.

At least one measuring apparatus 15 is installed in the accommodation unit 6. At least a part of the measuring apparatus 15 may be disposed outside the accommodation unit 6. In the example of the present embodiment, a plurality of measuring apparatuses 15 are installed in the accommodation unit 6. The measuring apparatus 15 includes a temperature sensor that measures the temperature of the environment in the accommodation unit 6. In addition, the measuring apparatus 15 includes a humidity sensor that measures the humidity of the environment in the accommodation unit 6. In addition, the measuring apparatus 15 includes a pressure sensor that measures the pressure of the environment in the accommodation unit 6. The temperature sensor is configured using a thermocouple, or a temperature measuring resistor, or the like. The measuring apparatus 15 may include a temperature sensor that measures a temperature of a refrigeration circuit included in a refrigerator or a dehumidifier of the environment control unit 5. In this case, the temperature sensor is disposed in the environment control unit 5, or is disposed outside the accommodation unit 6 and outside the environment control unit 5. The humidity sensor is, for example, a resistance type or capacitance type humidity sensor. The pressure sensor is configured using a pressure-sensitive element or the like, and when the accommodation unit 6 is a vacuum chamber or the like, the pressure sensor measures a pressure in the chamber. The measuring apparatus 15 may include a pressure sensor that measures a security pressure of a refrigeration pipe included in the refrigerator or the dehumidifier of the environment control unit 5. In this case, the pressure sensor is disposed outside the accommodation unit 6 and outside the environment control unit 5. The measuring apparatus 15 includes a communication unit 90 to be described later. The communication device 14 (second communication device) such as a communication substrate and/or an input/output substrate, or the like is connected to each of the plurality of measuring apparatuses 15. The communication device 14 is connected to the control device 11 via the communication network 17 using a LAN cable or the like. The communication device 14 communicates between the measuring apparatus 15 and the control device 11.

The electric apparatus 13 and the measuring apparatus 15 can be affected by various noises. The noise may cause a failure or a defect of the environment testing device 1. The noise includes high frequency noise that comes out as a radio wave, low frequency noise mixed from a power supply line or the like, single noise generated due to static electricity, or the like.

The control device 11 is configured using a microprocessor, a microcontroller, or the like.

The display device 12 is configured using a liquid crystal display, an organic EL display, or the like. The display device 12 may be configured using a touch panel display.

The environment testing device 1 is an example of an environment forming device. The environment testing device 1 evaluates performance or the like of the object W by applying temperature stress, or temperature stress and humidity stress to the object W. However, the environment forming device may be a heat treatment device or the like that performs heat treatment such as heating on the object W, or may be a vacuum heating device or the like that performs pressure treatment such as decompression on the object W.

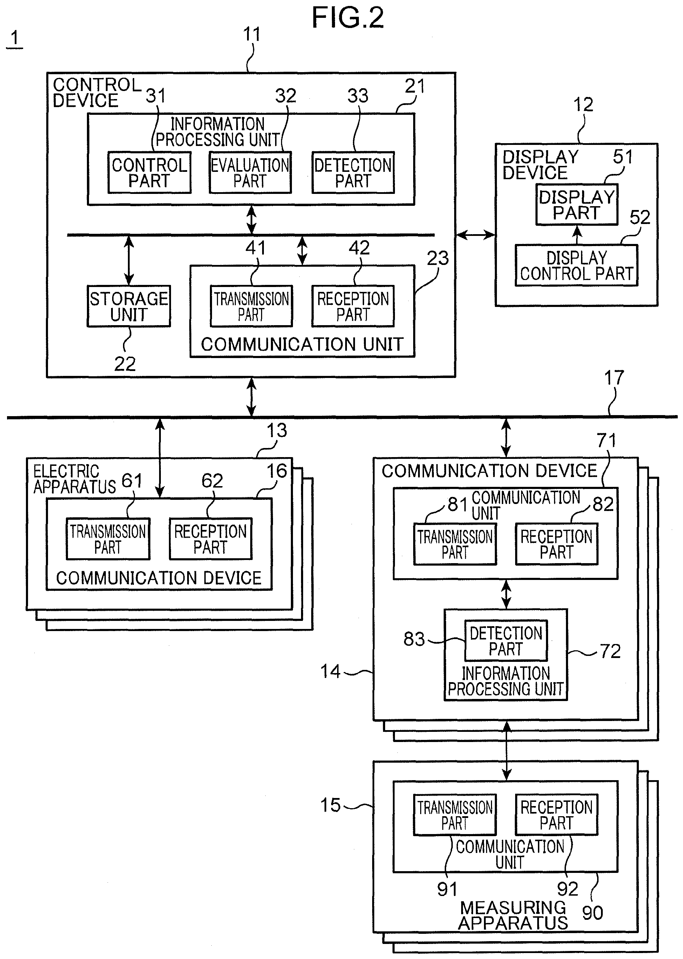

Fig. 2 is a diagram illustrating a simplified configuration of each part of the environment testing device 1.

The control device 11 includes an information processing unit 21, a storage unit 22, and a communication unit 23. The information processing unit 21 is configured using a processor such as a CPU. The storage unit 22 is configured using an HDD, an SSD, a semiconductor memory, or the like. The communication unit 23 is configured using a communication module corresponding to a predetermined communication protocol, and includes a transmission part 41 and a reception part 42. The information processing unit 21 includes a control part 31, an evaluation part 32, and a detection part 33 as functions implemented by the CPU executing a predetermined program. Processing contents of each processing part will be described later.

The display device 12 includes a display part 51 and a display control part 52. The display part 51 is configured using a liquid crystal display, an organic EL display, or the like. The display control part 52 generates image data of an image to be displayed on the display part 51. Details of the image to be displayed on the display part 51 will be described later. Note that the display control part 52 may be implemented not in the display device 12 but in the control device 11.

The communication device 16 is mounted on the electric apparatus 13. The communication device 16 is configured using a communication module corresponding to a predetermined communication protocol, and includes a transmission part 61 and a reception part 62.

The communication device 14 includes a communication unit 71 and an information processing unit 72. The communication unit 71 is configured using a communication module corresponding to a predetermined communication protocol, and includes a transmission part 81 and a reception part 82. The information processing unit 72 is configured using a processor such as a CPU. The information processing unit 72 includes a detection part 83 as a function implemented by the CPU executing a predetermined program. Processing contents of the detection part 83 will be described later.

The measuring apparatus 15 includes the communication unit 90. The communication unit 90 is configured using a communication module corresponding to a predetermined communication protocol, and includes a transmission part 91 and a reception part 92.

Hereinafter, operation of noise evaluation processing in the environment testing device 1 will be described. The noise evaluation processing is performed during execution of an environment test on the object W by the environment testing device 1.

The transmission part 61 (first transmission part) of the communication device 16 periodically transmits a digital signal to the control device 11 at a predetermined transmission interval. The digital signal may be a signal related to environment control in the accommodation unit 6 by the electric apparatus 13 (e.g., a response signal to a drive control command from the control device 11 to the electric apparatus 13), or may be a signal not related to the environment control.

The reception part 42 (first reception part) of the control device 11 receives the digital signal transmitted by the transmission part 61 included in each of the plurality of communication devices 16.

The detection part 33 (first detection part) of the control device 11 detects a code error occurring in the digital signal received by the reception part 42 for each of the plurality of communication devices 16. As a code error detection method, a well-known error detection method such as a parity bit method, a checksum method, or a CRC method can be used.

The evaluation part 32 evaluates an influence of noise on each of the plurality of electric apparatuses 13 based on a detection result of a code error obtained by the detection part 33. For example, the evaluation part 32 counts an instantaneous value and an accumulated value of the number of code errors detected by the detection part 33 (i.e., the number of bit errors) for each of the plurality of electric apparatuses 13. When the instantaneous value of the code error is less than a first threshold, the evaluation part 32 evaluates that an influence level of noise on the electric apparatus 13 is a low level (a normal level). When the instantaneous value of the code error is equal to or greater than the first threshold and less than a second threshold, the evaluation part 32 evaluates that the influence level of the noise on the electric apparatus 13 is a medium level (a warning level). When the instantaneous value of the code error is equal to or greater than the second threshold, the evaluation part 32 evaluates that the influence level of the noise on the electric apparatus 13 is a high level (an abnormal level). Note that the evaluation part 32 may evaluate an influence level of the noise using the accumulated value of the code error. Furthermore, the evaluation part 32 may evaluate an influence level of the noise in two stages or in four or more stages. Furthermore, the evaluation part 32 may evaluate an influence of the noise with one threshold.

The transmission part 91 (second transmission part) of the measuring apparatus 15 periodically transmits a digital signal toward the communication device 14 at a predetermined transmission interval. The digital signal may be a signal related to the environment control in the accommodation unit 6 by the measuring apparatus 15 (e.g., a response signal to the drive control command from the control device 11 to the measuring apparatus 15), or may be a signal not related to the environment control.

The reception part 82 (second reception part) of the communication device 14 receives the digital signal transmitted by the transmission part 91 of the corresponding measuring apparatus 15.

The detection part 83 (second detection part) of the communication device 14 detects a code error occurring in the digital signal received by the reception part 82. As a code error detection method, a well-known error detection method such as a parity bit method, a checksum method, or a CRC method can be used.

The transmission part 81 (second transmission unit) of the communication device 14 transmits data indicating a detection result obtained by the detection part 83 toward the control device 11.

The reception part 42 of the control device 11 receives the data transmitted by the transmission part 81. The evaluation part 32 evaluates an influence of the noise on the measuring apparatus 15 based on the detection result obtained by the detection part 83 and indicated by the data received by the reception part 42. In a case where the plurality of measuring apparatuses 15 are installed, the communication device 14 is connected to each of the plurality of measuring apparatuses 15. The evaluation part 32 evaluates an influence of the noise on each of the plurality of measuring apparatuses 15.

For example, the evaluation part 32 counts an instantaneous value and an accumulated value of the number of code errors detected by the detection part 83 (i.e., the number of bit errors) for each of the plurality of measuring apparatuses 15. When the instantaneous value of the code error is less than the first threshold, the evaluation part 32 evaluates that an influence level of noise on the measuring apparatus 15 is a low level (the normal level). When the instantaneous value of the code error is equal to or greater than the first threshold and less than a second threshold, the evaluation part 32 evaluates that the influence level of the noise on the measuring apparatus 15 is a medium level (the warning level). When the instantaneous value of the code error is equal to or greater than the second threshold, the evaluation part 32 evaluates that the influence level of the noise on the measuring apparatus 15 is a high level (the abnormal level). Note that the evaluation part 32 may evaluate an influence level of the noise using the accumulated value of the code error. Furthermore, the evaluation part 32 may evaluate an influence level of the noise in two stages or in four or more stages. Furthermore, the evaluation part 32 may evaluate an influence of the noise with one threshold. In addition, the evaluation part 32 may use different thresholds for the evaluation on the electric apparatus 13 and the evaluation on the measuring apparatus 15.

The control part 31 stores data indicating an evaluation result obtained by the evaluation part 32 in the storage unit 22 in association with detection time of a code error by the detection parts 33 and 83 and operation information of the environment testing device 1. The operation information includes, for example, information indicating a drive status (e.g., on or off) of each of the plurality of electric apparatuses 13, information indicating a drive status of each of the plurality of measuring apparatuses 15, or information indicating a measurement result (e.g., a temperature value, a humidity value, or a pressure value) of each of the plurality of measuring apparatuses 15.

In addition, the control part 31 inputs data indicating an evaluation result obtained by the evaluation part 32 to the display control part 52. The display control part 52 generates image data of an image indicating an evaluation result obtained by the evaluation part 32 based on data input from the control part 31. The display part 51 displays an image indicating an evaluation result obtained by the evaluation part 32 based on image data input from the display control part 52.

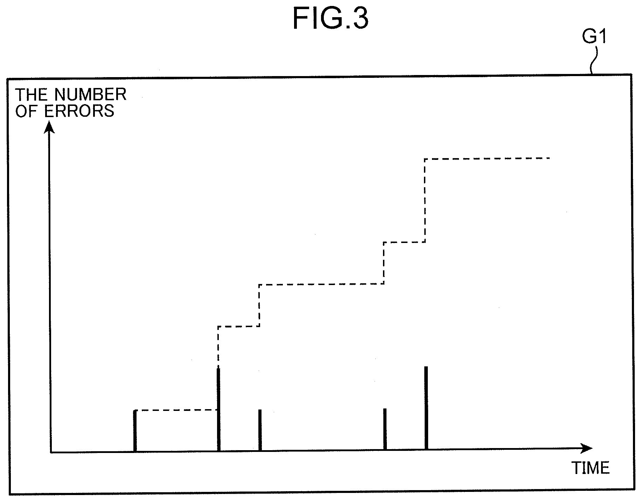

Fig. 3 is a diagram illustrating a first example of a display mode of an evaluation result in a simplified manner. In the first example, an image G1 is displayed on the display part 51. The image G1 includes a graph indicating an evaluation result. A horizontal axis of the graph represents time, and a vertical axis represents the number of errors. The number of errors corresponds to the number of bit errors. A bar graph indicated by a solid line represents an instantaneous value of the number of bit errors, and a line graph indicated by a broken line represents an accumulated value of the number of bit errors. The display part 51 is capable of displaying the image G1 for each of the plurality of electric apparatuses 13 and each of the plurality of measuring apparatuses 15.

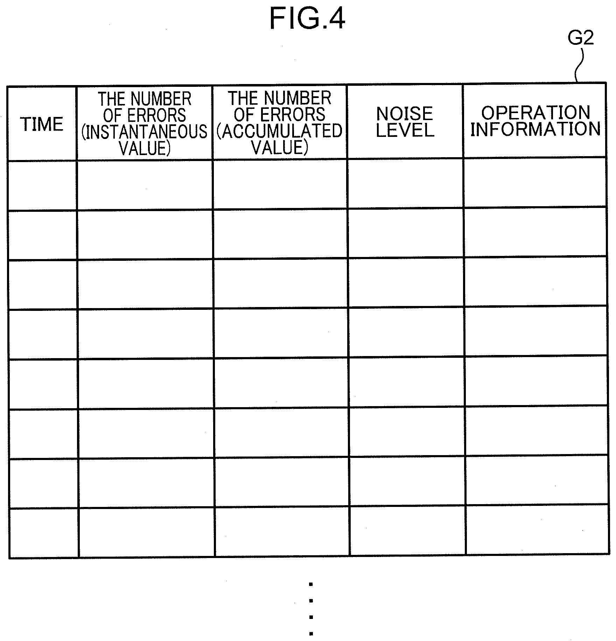

Fig. 4 is a diagram illustrating a second example of the display mode of an evaluation result in a simplified manner. In the second example, an image G2 is displayed on the display part 51. The image G2 includes a table indicating an evaluation result. The table includes items of time, the number of errors (instantaneous value), the number of errors (accumulated value), a noise level, and operation information. The time corresponds to detection time of a code error detected by the detection parts 33 and 83. The number of errors corresponds to the number of bit errors. The noise level corresponds to an influence level of noise. The operation information includes, for example, the information indicating a drive status of each of the plurality of electric apparatuses 13, the information indicating a drive status of each of the plurality of measuring apparatuses 15, or the information indicating a measurement result of each of the plurality of measuring apparatuses 15. The display part 51 is capable of displaying the image G2 for each of the plurality of electric apparatuses 13 and each of the plurality of measuring apparatuses 15.

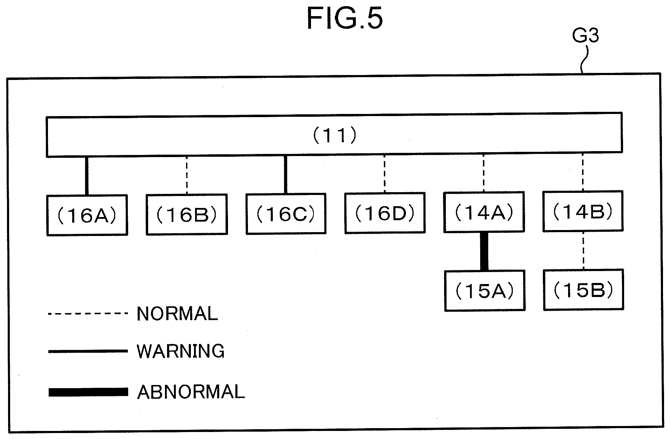

Fig. 5 is a diagram illustrating a third example of the display mode of an evaluation result in a simplified manner. In the third example, an image G3 is displayed on the display part 51. The image G3 includes a schematic diagram indicating an evaluation result. The schematic diagram includes a figure (11) representing the control device 11, figures (16A to 16D) representing the plurality of communication devices 16, respectively, figures (14A and 14B) representing the plurality of communication devices 14, respectively, and figures (15A and 15B) representing the plurality of measuring apparatuses 15, respectively. In addition, paths connecting the figure (11) and the figures (16A to 16D, 14A, and 14B) are displayed in a distinguishable manner by color-coding or the like according to the influence levels of noise. Similarly, paths connecting the figures (14A and 14B) and the figure (15A and 15B), respectively, are displayed in a distinguishable manner by color-coding or the like according to the influence levels of noise.

In the example of the above embodiment, the evaluation targets of the influence level of noise have been limited to the communication between the control device 11 and the communication device 16 and the communication between the communication device 14 and the measuring apparatus 15. Not limited to this example, communication between the control device 11 and the communication device 14, communication between the control device 11 and the display device 12, or the like may be included for the evaluation targets of the influence level of noise.

As described in the foregoing, according to the environment testing device 1 of the present embodiment, the detection part 33 (first detection part) detects a code error occurring in the digital signal received by the reception part 42 (first reception part), and the evaluation part 32 evaluates an influence of the noise on the electric apparatus 13 based on a detection result obtained by the detection part 33. It is accordingly possible to easily specify a spot affected by noise without using a measuring instrument such as an oscilloscope and evaluate an influence level of noise and the like in real time at the time of driving a device. This makes it possible to determine whether or not to continue driving the device.

In the environment testing device 1 according to the present embodiment, the detection part 33 detects a code error occurring in the digital signal received by the reception part 42 for each of the plurality of communication devices 16 (first communication devices), and the evaluation part 32 evaluates an influence of the noise on each of the plurality of electric apparatuses 13. It is accordingly possible to simultaneously measure noise at a plurality of spots in the environment testing device 1, resulting in enabling a spot affected by the noise, a propagation path, or the like of noise to be specifically specified.

Furthermore, according to the environment testing device 1 of the present embodiment, the detection part 83 (second detection part) detects a code error occurring in the digital signal received by the reception part 82 (second reception part), and the evaluation part 32 evaluates an influence of the noise on the measuring apparatus 15 based on a detection result obtained by the detection part 83. Accordingly, with respect not only to the electric apparatus 13 but also to the measuring apparatus 15, it is possible to easily specify a spot affected by noise without using a measuring instrument such as an oscilloscope and evaluate an influence level of noise and the like in real time at the time of driving a device.

In addition, according to the environment testing device 1 of the present embodiment, it is possible to visualize an evaluation result obtained by the evaluation part 32 and provide the evaluation result to an operator.

In addition, according to the environment testing device 1 of the present embodiment, since the data indicating an evaluation result obtained by the evaluation part 32 is stored in the storage unit 22, it is possible to perform a detailed analysis of a cause of noise generation and the like using the data stored in the storage unit 22 afterwards.

In addition, according to the environment testing device 1 of the present embodiment, since the data indicating the evaluation result obtained by the evaluation part 32 is stored in the storage unit 22 in association with the operation information of the environment testing device 1, it is possible to analyze a cause-and-effect relation, a correlation, or the like between drive of each electric apparatus 13 and the generation of noise in detail.

## Claims

1. An environment forming device (1) comprising:
a control device (11);
at least one electric apparatus (13) that can be affected by noise;
at least one first communication device (16) configured to communicate with the control device (11); and
an accommodation unit (6) configured to accommodate an object (W),
wherein the electric apparatus (13) is configured to control an environment in the accommodation unit (6),
the first communication device (16) is connected to the electric apparatus (13),
the first communication device (16) includes a first transmission part (61) configured to transmit a digital signal toward the control device (11), and
the control device (11) includes:
a first reception part (42) configured to receive the digital signal transmitted by the first transmission part (61);
a first detection part (33) configured to detect a code error occurring in the digital signal received by the first reception part (42); and
an evaluation part (32) configured to evaluate an influence of noise on the electric apparatus based (13) on a detection result obtained by the first detection part.

2. The environment forming device (1) according to claim 1, wherein
the at least one electric apparatus (13) includes a plurality of electric apparatuses (13),
the at least one first communication device (16) includes a plurality of first communication devices (16),
each of the plurality of first communication devices (16) being connected to each of the plurality of electric apparatuses (13),
the first reception part (42) configured to receive the digital signal transmitted by the first transmission part (61) included in each of the plurality of first communication devices (16),
the first detection part (33) configured to detect a code error occurring in the digital signal received by the first reception part (42) for each of the plurality of first communication devices (16), and
the evaluation part (32) configured to evaluate an influence of noise on each of the plurality of electric apparatuses (13).

3. The environment forming device (1) according to claim 1, further comprising:
a measuring apparatus (15) that can be affected by noise; and
a second communication device (14) configured to communicate with the control device (11) and the measuring apparatus (15),
wherein the measuring apparatus (15) is at least one of a temperature sensor, a humidity sensor, and a pressure sensor,
the measuring apparatus (15) includes a second transmission part (91) configured to transmit a digital signal toward the second communication device (14),
the second communication device (14) includes:
a second reception part (82) configured to receive the digital signal transmitted by the second transmission part (91);
a second detection part (83) configured to detect a code error occurring in the digital signal received by the second reception part (82); and
a second transmission part (81) configured to transmit data indicating a detection result obtained by the second detection part (83) to the control device (11),
the first reception part (42) is further configured to receive the data transmitted by the second transmission part (81), and
the evaluation part (32) is further configured to evaluate an influence of noise on the measuring apparatus (15) based on a detection result obtained by the second detection part (83), the detection result being indicated by the data received by the first reception part (42).

4. The environment forming device (1) according to claim 1, further comprising a display device (12) configured to display an image indicating an evaluation result obtained by the evaluation part (32).

5. The environment forming device (1) according to claim 1, wherein the control device (11) further includes a storage unit (22) configured to store data indicating an evaluation result obtained by the evaluation part (32).

6. The environment forming device according (1) to claim 5, wherein
the control device (11) further includes a control part (31),
the control part (31) configured to store
the data indicating the evaluation result obtained by the evaluation part (32) in the storage unit (22) in association with operation information of the environment forming device (1).

## Patentansprüche

1. Umgebungserzeugungsvorrichtung (1), umfassend:
eine Steuervorrichtung (11);
mindestens ein elektrisches Gerät (13), das durch Rauschen beeinflussbar ist;
mindestens eine erste Kommunikationsvorrichtung (16), die dazu eingerichtet ist, mit der Steuervorrichtung (11) zu kommunizieren; und
eine Aufnahmevorrichtung (6), die dazu eingerichtet ist, ein Objekt (W) aufzunehmen,
wobei das elektrische Gerät (13) dazu eingerichtet ist, eine Umgebung in der Aufnahmevorrichtung (6) zu steuern,
die erste Kommunikationsvorrichtung (16) mit dem elektrischen Gerät (13) verbunden ist,
die erste Kommunikationsvorrichtung (16) einen ersten Übertragungsteil (61) umfasst, der dazu eingerichtet ist, ein digitales Signal an die Steuervorrichtung (11) zu übertragen, und
die Steuervorrichtung (11) umfasst:
einen ersten Empfangsteil (42), der dazu eingerichtet ist, das von dem ersten Übertragungsteil (61) übertragene digitale Signal zu empfangen;
einen ersten Detektionsteil (33), der dazu eingerichtet ist, einen Codefehler zu detektieren, der in dem von dem ersten Empfangsteil (42) empfangenen digitalen Signal auftritt; und
einen Auswertungsteil (32), der dazu eingerichtet ist, einen Einfluss von Rauschen auf das elektrische Gerät (13) auf Grundlage eines von dem ersten Detektionsteil erhaltenen Detektionsergebnisses zu bewerten.

2. Umgebungserzeugungsvorrichtung (1) nach Anspruch 1, wobei
das mindestens eine elektrische Gerät (13) mehrere elektrische Geräte (13) umfasst und die mindestens eine erste Kommunikationsvorrichtung (16) mehrere erste Kommunikationsvorrichtungen (16) umfasst,
jede der mehreren ersten Kommunikationsvorrichtungen (16) mit jeweils einem der mehreren elektrischen Geräte (13) verbunden ist,
der erste Empfangsteil (42) dazu eingerichtet ist, das von dem ersten Übertragungsteil (61) übertragene digitale Signal zu empfangen, der jeweils in jeder der mehreren ersten Kommunikationsvorrichtungen (16) enthalten ist,
der erste Detektionsteil (33) dazu eingerichtet ist, für jede der mehreren ersten Kommunikationsvorrichtungen (16) einen Codefehler zu detektieren, der in dem von dem ersten Empfangsteil (42) empfangenen digitalen Signal auftritt, und
der Auswertungsteil (32) dazu eingerichtet ist, einen Einfluss von Rauschen auf jedes der mehreren elektrischen Geräte (13) zu bewerten.

3. Umgebungserzeugungsvorrichtung (1) nach Anspruch 1, ferner umfassend:
eine Messeinrichtung (15), die durch Rauschen beeinflussbar ist; und
eine zweite Kommunikationsvorrichtung (14), die dazu eingerichtet ist, mit der Steuervorrichtung (11) und der Messeinrichtung (15) zu kommunizieren,
wobei die Messeinrichtung (15) mindestens eine aus einem Temperatursensor, einem Feuchtigkeitssensor und einem Drucksensor ist,
die Messeinrichtung (15) einen zweiten Übertragungsteil (91) umfasst, der dazu eingerichtet ist, ein digitales Signal an die zweite Kommunikationsvorrichtung (14) zu übertragen,
die zweite Kommunikationsvorrichtung (14) umfasst:
einen zweiten Empfangsteil (82), der dazu eingerichtet ist, das von dem zweiten Übertragungsteil (91) übertragene digitale Signal zu empfangen;
einen zweiten Detektionsteil (83), der dazu eingerichtet ist, einen Codefehler zu detektieren, der in dem von dem zweiten Empfangsteil (82) empfangenen digitalen Signal auftritt; und
einen zweiten Übertragungsteil (81), der dazu eingerichtet ist, Daten, die ein von dem zweiten Detektionsteil (83) erhaltenes Detektionsergebnis anzeigen, an die Steuervorrichtung (11) zu übertragen,
der erste Empfangsteil (42) ferner dazu eingerichtet ist, die von dem zweiten Übertragungsteil (81) übertragenen Daten zu empfangen, und
der Auswertungsteil (32) ferner dazu eingerichtet ist, einen Einfluss von Rauschen auf die Messeinrichtung (15) auf Grundlage eines von dem zweiten Detektionsteil (83) erhaltenen Detektionsergebnisses zu bewerten, wobei das Detektionsergebnis durch die von dem ersten Empfangsteil (42) empfangenen Daten angezeigt wird.

4. Umgebungserzeugungsvorrichtung (1) nach Anspruch 1, ferner umfassend eine Anzeigevorrichtung (12), die dazu eingerichtet ist, ein Bild anzuzeigen, das ein von dem Auswertungsteil (32) erhaltenes Auswertungsergebnis anzeigt.

5. Umgebungserzeugungsvorrichtung (1) nach Anspruch 1, wobei die Steuervorrichtung (11) ferner eine Speichereinheit (22) umfasst, die dazu eingerichtet ist, Daten zu speichern, die ein von dem Auswertungsteil (32) erhaltenes Auswertungsergebnis anzeigen.

6. Umgebungserzeugungsvorrichtung (1) nach Anspruch 5, wobei
die Steuervorrichtung (11) ferner einen Steuerteil (31) umfasst,
wobei der Steuerteil (31) dazu eingerichtet ist, die Daten, die das von dem Auswertungsteil (32) erhaltene Auswertungsergebnis anzeigen, in der Speichereinheit (22) in Zuordnung zu Betriebsinformationen der Umgebungserzeugungsvorrichtung (1) zu speichern.

## Revendications

1. Dispositif de mise en condition climatique (1) comprenant :
un dispositif de commande (11),
au moins un appareil électrique (13) susceptible d'être affecté par du bruit,
au moins un premier dispositif de communication (16) conçu pour communiquer avec le dispositif de commande (11), et
une unité de logement (6) conçue pour loger un objet (W) ;
l'appareil électrique (13) étant conçu pour réguler un environnement régnant dans l'unité de logement (6),
le premier dispositif de communication (16) étant raccordé à l'appareil électrique (13),
le premier dispositif de communication (16) comprenant une première partie d'émission (61) conçue pour émettre un signal numérique à destination du dispositif de commande (11), et
le dispositif de commande (11) comprenant :
une première partie de réception (42) conçue pour recevoir le signal numérique émis par la première partie d'émission (61),
une première partie de détection (33) conçue pour détecter une erreur de code présente dans le signal numérique reçu par la première partie de réception (42), et
une partie d'évaluation (32) conçue pour évaluer l'influence du bruit sur l'appareil électrique (13) en fonction du résultat de détection obtenu par la première partie de détection.

2. Dispositif de mise en condition climatique (1) selon la revendication 1, dans lequel
l'au moins un appareil électrique (13) comprend une pluralité d'appareils électriques (13),
l'au moins un premier dispositif de communication (16) comprend une pluralité de premiers dispositifs de communication (16),
chacun des premiers dispositifs de communication (16) est raccordé à chacun des appareils électriques (13),
la première partie de réception (42) est conçue pour recevoir le signal numérique émis par la première partie d'émission (61) comprise dans chacun des premiers dispositifs de communication (16),
la première partie de détection (33) est conçue pour détecter une erreur de code présente dans le signal numérique reçu par la première partie de réception (42) relativement à chacun des premiers dispositifs de communication (16), et
la partie d'évaluation (32) est conçue pour évaluer l'influence du bruit sur chacun des appareils électriques (13).

3. Dispositif de mise en condition climatique (1) selon la revendication 1, comprenant en outre :
un appareil de mesure (15) susceptible d'être affecté par du bruit, et
un deuxième dispositif de communication (14) conçu pour communiquer avec le dispositif de commande (11) et l'appareil de mesure (15) ;
l'appareil de mesure (15) étant un capteur de température, un capteur d'humidité et/ou un capteur de pression,
l'appareil de mesure (15) comprenant une deuxième partie d'émission (91) conçue pour émettre un signal numérique à destination du deuxième dispositif de communication (14),
le deuxième dispositif de communication (14) comprenant :
une deuxième partie de réception (82) conçue pour recevoir le signal numérique émis par la deuxième partie d'émission (91),
une deuxième partie de détection (83) conçue pour détecter une erreur de code présente dans le signal numérique reçu par la deuxième partie de réception (82), et
une deuxième partie d'émission (81) conçue pour émettre des données indiquant un résultat de détection obtenu par la deuxième partie de détection (83) à destination du dispositif de commande (11) ;
la première partie de réception (42) étant en outre conçue pour recevoir les données émises par la deuxième partie d'émission (81), et
la partie d'évaluation (32) étant en outre conçue pour évaluer l'influence du bruit sur l'appareil de mesure (15) en fonction d'un résultat de détection obtenu par la deuxième partie de détection (83), le résultat de détection étant indiqué par les données reçues par la première partie de réception (42).

4. Dispositif de mise en condition climatique (1) selon la revendication 1, comprenant en outre un dispositif d'affichage (12) conçu pour afficher une image indiquant un résultat d'évaluation obtenu par la partie d'évaluation (32).

5. Dispositif de mise en condition climatique (1) selon la revendication 1, dans lequel le dispositif de commande (11) comprend en outre une unité de stockage (22) conçue pour y stocker des données indiquant un résultat d'évaluation obtenu par la partie d'évaluation (32).

6. Dispositif de mise en condition climatique (1) selon la revendication 5, dans lequel
le dispositif de commande (11) comprend en outre une partie de commande (31) ;
la partie de commande (31) étant conçue pour stocker les données indiquant le résultat d'évaluation obtenu par la partie d'évaluation (32) dans l'unité de stockage (22) en association avec des informations de fonctionnement du dispositif de mise en condition climatique (1).
